# EUROPÄISCHE PATENTSCHRIFT

(11) **EP 3 289 601 B1**
(45) Veröffentlichungstag und Bekanntmachung des Hinweises auf die Patenterteilung: **23.01.2019**
(21) Anmeldenummer: 16723276.8
(22) Anmeldetag: 28.04.2016
(51) Int. Cl.: H01J 37/244, H01J 37/317, H01J 49/02

(54) **VORRICHTUNG ZUR DETEKTION EINZELNER GELADENER TEILCHEN SOWIE SYSTEM ZUR MATERIALBEARBEITUNG MIT EINER SOLCHEN VORRICHTUNG**
APPARATUS FOR DETECTING INDIVIDUAL CHARGED PARTICLES AND MATERIAL PROCESSING SYSTEM HAVING SUCH AN APPARATUS
DISPOSITIF DE DÉTECTION DE PARTICULES CHARGÉES INDIVIDUELLES ET SYSTÈME D'USINAGE DE MATÉRIAU AU MOYEN D'UN TEL DISPOSITIF

(30) Priorität: 30.04.2015 DE 102015106769
(43) Veröffentlichungstag der Anmeldung: 07.03.2018
(73) Patentinhaber: Leibniz-Institut für Oberflächenmodifizierung e.V., 04303 Leipzig (DE)
(72) Erfinder: GERLACH, Jürgen W., 04315 Leipzig (DE); MEIJER, Jan, 44892 Bochum (DE); PEZZAGNA, Sèbastian, 04275 Leipzig (DE); RAUSCHENBACH, Bernd, 04827 Machern (DE); RAUSCHENBACH, Stephan, 70565 Stuttgart (DE); SPEMANN, Daniel, 04275 Leipzig (DE)
(74) Vertreter: Gulde & Partner
(86) Internationale Anmeldenummer: PCT/EP2016/059565
(87) Internationale Veröffentlichungsnummer: WO 2016/174177

(56) Entgegenhaltungen:
- US-A- 5 591 969
- US-A1- 2011 240 845
- US-B2- 6 784 421
- HOSKINS M J ET AL: "Acoustic Charge Transport Principles and Performance", 40TH ANNUAL SYMPOSIUM ON FREQUENCY CONTROL. 1986, IEEE, 28. Mai 1986 (1986-05-28), Seiten 285-291, XP032285565, DOI: 10.1109/FREQ.1986.200955
- SZAJNOWSKI ET AL: "Measurement of ion beam parameters with electrostatic induction electrodes", VACUUM, PERGAMON PRESS, GB, Bd. 34, Nr. 1-2, 1. Januar 1984 (1984-01-01), Seiten 285-289, XP025734062, ISSN: 0042-207X, DOI: 10.1016/0042-207X(84)90143-X [gefunden am 1984-01-01]
- SCHMIDT STEFAN ET AL: "Non-destructive single-pass low-noise detection of ions in a beamline", REVIEW OF SCIENTIFIC INSTRUMENTS, AIP, MELVILLE, NY, US, Bd. 86, Nr. 11, 1. Januar 1901 (1901-01-01), XP012202372, ISSN: 0034-6748, DOI: 10.1063/1.4935551 [gefunden am 1901-01-01]

## Beschreibung

Die Erfindung betrifft eine Vorrichtung zur Detektion einzelner geladener Teilchen sowie ein darauf beruhendes System zur Materialbearbeitung.

### Technologischer Hintergrund

Die Herstellung von Sensoren mittels Funktionalisierung einzelner Atome, Moleküle, Cluster etc. benötigt Verfahren, um diese Objekte oder Teilchen zu manipulieren. Dabei kommt insbesondere geladenen Objekten oder Teilchen aufgrund der möglichen Kontrolle durch elektromagnetische Felder eine besondere Bedeutung zu. Für deren Manipulation es nicht nur notwendig, diese geladenen Objekte oder Teilchen lagegenau zu platzieren (bzw. in einer Materialprobe zu implantieren), sondern diese Objekte auch zählen und sortieren zu können.

Eine Platzierung einzelner geladener Teilchen kann erreicht werden, indem ein entsprechender Teilchenstrahl sehr stark ausgedünnt über einem Substrat bewegt oder der Strahl mittels elektrischer oder mechanischer Verfahren schnell an- und abgeschaltet wird, so dass im Mittel nur ein einzelnes Ion platziert werden kann. Ohne den expliziten Nachweis eines jeden Teilchens kann mit dieser Methode jedoch nur der statistische Mittelwert der platzierten Teilchen am Platzierungsort definiert werden, während die exakte Zahl an platzierten Teilchen nicht kontrolliert werden kann. Durch Kombination mit einer Vorrichtung zur Detektion einzelner geladener Teilchen, welche ein Zählen und Sortieren dieser Teilchen erlaubt, ermöglicht das Verfahren jedoch, eine frei wählbare, abzählbare Anzahl an Teilchen lagegenau zu platzieren.

Während für die lagegenaue Platzierung von geladenen Teilchen verschiedene Methoden entwickelt wurden, ist das Zählen und Sortieren einzelner geladener Teilchen bislang nur durch starke Beeinflussung der kinetischen Energie und Bewegungsrichtung des Objektes möglich. Dies verhindert jedoch ein lagegenaues Platzieren.

Für eine lagegenaue Platzierung einzelner geladener Teilchen sollte eine ideale Detektion folgende Bedingungen erfüllen:
1. Das geladene Teilchen sollte nicht oder nur unwesentlich von der Detektion beeinflusst werden.
2. Die Detektion sollte unabhängig von Teilchengrößen, kinetischer Energie, Art oder Ladung des Teilchens möglich sein (neutrale Teilchen nicht inbegriffen).
3. Die Detektion sollte so schnell erfolgen, dass eine hohe Platzierungsrate möglich ist.
4. Die Detektion sollte unabhängig von einem Substrat möglich sein.

Aus dem Stand der Technik sind drei unterschiedliche Verfahren dazu bekannt:
1. Ein Substrat wird als Detektor bzw. als Sekundärelektronenemitter genutzt und die geladenen Teilchen werden beim Auftreffen gezählt.
2. Die geladenen Teilchen werden beim Durchdringen einer dünnen Folie oder eines dünnen pn-Sperrschichtzählers detektiert.
3. Es wird eine lonenfalle genutzt, die nur jeweils ein Teilchen in einem bestimmten Zeitintervall liefert.

Für alle drei Methoden gibt es zahlreiche Ausführungen und Anwendungen. Allerdings besitzen alle Verfahren Nachteile und erfüllen nicht die genannten idealen Bedingungen für eine lagegenaue Platzierung. Methode 1 ist nur für eine bestimmte Art von Anwendungen nutzbar, da das Substrat im Allgemeinen keine Teilchendetektion gestattet. Die Emission von Sekundärelektronen, die beim Auftreffen des Teilchens auf ein Substrat entstehen, ist ebenfalls nur im Fall ausreichend hoher kinetischer Energien möglich, wobei die Nachweissicherheit des Teilchens selbst dann für viele Anwendungen unzureichend ist. Methode 2 führt zu einer Verbreiterung der Energieverteilung sowie zur Streuung der Teilchen und kann daher nicht genutzt werden, wenn eine lagegenaue Implantation oder Platzierung benötigt wird. Methode 3 kann für einzelne Ionen als auch für Cluster und Moleküle genutzt werden. Für die Implantation einzelner Ionen wurde damit bereits eine laterale Auflösung von 5 nm erzielt. Diese Methode ist jedoch nur für bestimmte lonensorten geeignet und mit einem sehr hohen technischen Aufwand verbunden. Nachteil der Methode ist zudem die geringe lonenrate. Bislang kann mit einer solchen Methode nur eine Rate von etwa einem Ion pro Sekunde erreicht werden.

Eine weitere Methode nach dem Stand der Technik, die nur in einem sehr geringen Maße zu einer Beeinflussung der kinetischen Energie oder der Richtung der geladenen Teilchen führt, ist die Detektion der von einem Teilchen auf einer leitenden Oberfläche influenzierten Spiegelladung. Darüber hinaus können Spiegelladungen mit hoher Geschwindigkeit abgetastet werden, so dass eine sehr schnelle Detektion des geladenen Teilchens ermöglicht wird. Der durch eine beliebige Anzahl bewegter elektrischer Ladungen in einer beliebig geformten multidimensionalen Struktur mit einer Vielzahl von Kontakten influenzierte Klemmenstrom kann dabei gemäß dem Ramo-Shockley Theorem genau bestimmt werden.

Die Detektion von geladenen Teilchen mittels influenzierter Spiegelladungen ist im Bereich der Massenspektrometrie bekannt und kann z.B. mit einem makroskopischen Faraday-Becher in einer Ionenfalle oder durch eine lineare Anordnung von wenigen makroskopischen Faraday-Bechern erreicht werden, es wird z.B. auf die Anmeldung US 2011/0240845 A1 verwiesen. Ziel dieser Verfahren ist die Bestimmung der Masse eines großen geladenen Molekülclusters mit einer Ladung von mindestens Q = 20e (e: Elementarladung), um eine sichere Detektion zu gewährleisten. Eine lagegenaue Platzierung leichter und kleiner Ionen und Moleküle bzw. von Objekten mit geringerer Ladung ist hingegen mit einem solchen Verfahren nicht möglich. Zudem wird durch die Teilchendetektion die Emittanz der Teilchenstrahlung stark vergrößert, so dass eine anschließende Fokussierung keine ausreichende Genauigkeit für eine lagegenaue Platzierung einzelner geladener Teilchen liefert. Außerdem ist durch eine zeitaufwendige Signalverarbeitung bei diesem Verfahren nur eine sehr langsame Teilchendetektion möglich.

Der Erfindung liegt daher die Aufgabe zugrunde, eine Vorrichtung zur Detektion einzelner geladener Teilchen zur Verfügung zu stellen, die eines oder mehrere der geschilderten Probleme des Standes der Technik bei der Detektion und lagegenauen Platzierung einzelner geladener Teilchen auch geringer Ladung und Masse vermeidet oder zumindest deutlich mindert. Insbesondere soll besagte Vorrichtung das zu detektierende geladene Teilchen sehr schnell erkennen können, dabei nicht oder nur unwesentlich in Energie, Impuls und Bewegungsrichtung beeinflussen, sowie unabhängig von dessen Größe, kinetischer Energie, Art oder Ladung sein. Zudem soll auch nach der Teilchendetektion in Kombination mit fokussierenden Elementen die Emittanz der Teilchenstrahlung ausreichend gering für eine lagegenaue Platzierung der geladenen Teilchen sein.

### Zusammenfassung der Erfindung

Die genannte Aufgabe wird mit Hilfe der erfindungsgemäßen Vorrichtung nach Anspruch 1 gelöst. Die Erfindung stellt eine Vorrichtung zur Detektion eines einzelnen geladenen Teilchens im einfachen freien Durchflug zur Verfügung. Die Vorrichtung umfasst mindestens zwei Elektrodenanordnungen mit einer Vielzahl von regelmäßig angeordneten Elektroden, wobei die Elektroden der Elektrodenanordnungen quer zur Flugrichtung des Teilchens so übereinander positioniert sind, dass sich ein konstanter Abstand zwischen den jeweiligen Elektroden ergibt und die Elektroden exakt übereinanderliegend ausgerichtet sind dergestalt, dass das zu detektierende Teilchen den so gebildeten Zwischenraum im freien Flug durchquert. Weiterhin umfasst die Vorrichtung eine Schaltung, bei der Paare aus sich gegenüberliegenden Elektroden über Verbindungsleitungen elektrisch miteinander verbunden und über ladungsempfindliche Verstärkungsvorrichtungen auf Sammelleitungen geschaltet sind.

Der Erfindung liegt die Erkenntnis zugrunde, dass durch eine bestimmte und grundlegend von den bekannten Faraday-Bechern abweichende Formgebung, Größe und Anzahl der sensitiven Elektroden eine Anpassung an die Bedürfnisse der lagegenauen Platzierung leichter Ionen und Moleküle möglich ist, wobei auch nach der Teilchendetektion die Emittanz einer derart aufgebauten Quelle für einzelne, abzählbare Teilchen klein genug ist, um in Kombination mit fokussierenden Elementen eine lagegenaue Platzierung der Teilchen zu ermöglichen. Zudem wird dadurch die Detektion von Teilchen mit einer Ladung Q von nur einer Ladungseinheit e möglich, da die Bestimmung der Teilchenmassen in einer solchen Ausführung nur sekundär ist.

Die durch geladene Teilchen an einzelnen Elektroden eines solchen erfindungsgemäß abgewandelten Faraday-Bechers durch die erzeugten Spiegelladungen influenzierten Ladungsverschiebungen können beispielsweise als Ströme abgegriffen und über geeignete Verstärkungseinrichtungen derart verstärkt werden, dass das erhaltene Messsignal zu einem für eine weitere elektronische Verarbeitung geeigneten Detektionssignal geformt werden kann. Insbesondere erfolgt bei symmetrisch bezüglich der realisierten Elektrodenanordnung und Teilchenbahn aufgebauten Detektionsanordnungen auch eine vorwiegend symmetrische Spiegelladungserzeugung in beiden Elektrodenanordnungen, so dass ein detektiertes Teilchen nur geringfügig aus seiner ursprünglichen Flugbahn abgelenkt wird. Da zudem die abgegriffenen Signale dem zu detektierendem System nur geringfügig Energie entziehen und auch sonst nur eine vernachlässigbare Wechselwirkung des geladen Teilchens mit der erfindungsgemäßen Faraday-Anordnung besteht, bleiben Teilchengeschwindigkeit, -energie, -masse und - ladung weitgehend erhalten. Insbesondere wird hierbei infolge der Detektion die kinetische Energie der Teilchen um wenige eV, idealerweise weniger als 1 eV und die Bewegungsrichtung um weniger als 0.1 mrad geändert.

In einer bevorzugten Ausführungsform der erfindungsgemäßen Vorrichtung zur Detektion einzelner geladener Teilchen ist vorgesehen, dass die genannten Elektrodenanordnungen jeweils als ineinandergreifende Elektrodenkämme mit einer Vielzahl von Zähnen, welche die einzelnen Elektroden bilden, ausgeformt sind. Diese Elektroden sind vorzugsweise planar ausgelegt und befinden sich bevorzugt auf einem nichtleitenden isolierenden Trägermaterial bzw. Trägersubstrat. Dabei werden die Elektroden vorzugsweise durch Abscheidung auf das Substrat aufgebracht und aus einem leitenden metallischen Material, insbesondere Gold, aufgebaut bzw. strukturiert. Die einzelnen Elektroden der jeweiligen Elektrodenkämme können über gemeinsame Verbindungsleitungen elektrisch miteinander verbunden sein.

Der Abstand zwischen gegenüberliegenden Elektroden eines Elektrodenpaares beträgt 100 nm bis 10 mm, vorzugsweise 0.1 bis 100 µm. Eine Breite der einzelnen Elektroden beträgt vorzugsweise 100 nm bis 10 mm, insbesondere 0.1 bis 100 µm. Die beiden Elektrodenanordnungen können 10² bis 10⁶ Elektrodenpaare, vorzugsweise 10³ bis 10⁶ Elektrodenpaare, beispielsweise 10⁴ Elektrodenpaare, umfassen. Durch eine geeignete Kontaktierung der jeweiligen Elektrodenanordnungen auf beiden Substraten wird erreicht, dass diese zugehörigen Elektroden beidseitig offene Faradaykäfige bilden können, durch die das zu detektierende Teilchen im freien Flug durchtritt und dabei auf den Elektroden eine der Ladung des Teilchens entsprechende Spiegelladung influenziert wird. Die aus einzelnen Elektroden aufgebauten offenen Faraday-Käfige bilden eine Anordnung aus Elementarkondensatoren, welche ihrerseits jeweils einzelne elektromagnetische Resonatoren mit einer bestimmten Resonanzfrequenz darstellen. Die Resonanzfrequenz kann insbesondere an eine experimentell vorgegebene Geschwindigkeit der geladen Teilchen und damit an die Veränderungsrate der dadurch influenzierten Spiegelladung angepasst sein.

Die einzelnen Elektrodenpaare des Detektors können dabei erfindungsgemäß in mehrere Elektrodengruppen unterteilt werden, wobei die darin influenzierten Spiegelladungen jeweils geeignet verstärkt und auf gemeinsame Sammelleitungen abgeleitet werden können. Mit anderen Worten, zwei oder mehr aufeinanderfolgende Paare sich gegenüberliegender Elektroden sind vorzugsweise zu Elektrodengruppen zusammengefasst, denen Verstärkungsvorrichtungen zugeordnet sind. Insbesondere werden innerhalb einer solchen Elektrodengruppe alle Elektroden von sich gegenüberliegenden Elektrodenkämmen auf diese Weise zu gemeinsamen Signalgruppen miteinander verknüpft. Vorzugsweise umfasst eine Elektrodengruppe jeweils 50 bis 5*10² Elektrodenpaare. Der gesamte Detektor umfasst vorzugsweise 50 bis 5*10², beispielsweise 100, Elektrodengruppen.

Die Sammelleitungen sind vorzugsweise so gestaltet, dass die Signale der einzelnen Elektrodengruppen zeitrichtig entsprechend der geometrischen Abfolge der Elektroden gesammelt und abgeführt werden können. Die Signale der einzelnen Sammelleitungen können zur Erzeugung eines Detektionssignales genutzt werden, das anschließend einer nachgeschalteten Elektronik zugeführt und weiter prozessiert werden kann. Das erzeugte Detektionssignal erlaubt neben einer reinen Detektion und Zählung einzelner geladener Teilchen durch Bezugnahme auf zusätzlich bekannte Parameter der Detektoranordnung unter Umständen auch Rückschlüsse auf weitere bisher unbekannte Teilcheneigenschaften. Insbesondere kann der erfindungsgemäße Detektor oder eine Kombination von solchen Detektoren zur Messung der Geschwindigkeit bzw. von Energie und Impuls der geladenen Teilchen genutzt werden. Weiterhin sind auch eine chemische Selektion und/oder eine Selektion von bestimmten Isotopen der detektierten Teilchen mit Hilfe einer erfindungsgemäßen Detektoranordnung realisierbar. Weiterhin ist eine Anwendung der erfindungsgemäßen Vorrichtung zur Detektion einzelner geladener Teilchen auch als Messgerät zur Detektion einzelner oder abzählbar vieler gestreuter Teilchen von beispielweise einer Streuprobe oder aus einen bestimmten Raumwinkelgebiet möglich.

Zur Reduzierung des elektronischen Rauschens und damit zur Verbesserung der Nachweiseffizienz bzw. der Nachweissicherheit einzelner geladener Teilchen kann die gesamte Vorrichtung im Betrieb auf eine reduzierte Arbeitstemperatur, bevorzugt auf Temperaturen um 100 K, durch eine entsprechende Kühlungseinrichtung gekühlt werden.

In einer weiteren bevorzugten Ausführungsform der Erfindung ist vorgesehen, dass die erfindungsgemäße Vorrichtung zur Detektion einzelner geladener Teilchen in einem System zur Detektion und lagegenauen Platzierung von einzelnen geladenen Teilchen genutzt wird. Das System umfasst ferner einen Strahlunterbrecher und eine Fokussiereinrichtung. Durch die durch die erfindungsgemäße Vorrichtung zur Detektion einzelner geladener Teilchen realisierte Möglichkeit zur schnellen Verarbeitung der durch die Spiegelladung erzeugten Signale kann eine nachgeschaltete Elektronik beispielsweise einen entsprechend schnell arbeitenden Strahlunterbrecher (Beam-Blanker) ansteuern, so dass in Kombination mit einer geeigneten, vorzugsweise steuer- oder regelbaren, Fokussierungseinrichtung gezielt nur einzelne oder eine abzählbar geringe Anzahl von geladenen Teilchen lagegenau auf oder innerhalb einer Probe platziert werden können. Dies kann insbesondere dazu genutzt werden, um damit einzelnen Atomen, Molekülen oder Clustern in einem Material eine konkrete Funktion zu übertragen und beispielsweise Atome als Schalter, als quantenmechanische Objekte oder als Quelle für einzelne Lichtteilchen einsetzen zu können. Darüber hinaus können solche Teilchen lokal auch eine chemische Funktionalität anbieten. Anwendungen finden sich z.B. innerhalb der Informationsverarbeitung, bei Quantencomputern und in der Kryptologie. Des Weiteren kann die erfindungsgemäße Umsetzung eines solchen Systems zur Detektion und lagegenauen Platzierung einzelner geladener Teilchen zur gezielten Materialbearbeitung und/oder zur Oberflächenmodifikation genutzt werden. Weiterhin ist ein gezielter Durchschuss eines Probenmaterials mit einzelnen oder abzählbar vielen einzelnen Teilchen möglich.

### Kurzbeschreibung der Figuren

Die Erfindung wird nachfolgend anhand eines Ausführungsbeispiels und dazugehöriger Zeichnungen näher erläutert. Die Figuren zeigen:
Fig. 1 eine schematische Aufsichtsdarstellung einer möglichen Elektrodenanordnung für eine erfindungsgemäße Vorrichtung zur Detektion einzelner geladener Teilchen;
Fig. 2 eine schematische Darstellung von Bestandteilen einer erfindungsgemäßen Vorrichtung zur Detektion einzelner geladener Teilchen;
Fig. 3 eine schematische Schnittdarstellung der Vorrichtung gemäß Fig. 2;
Fig. 4 eine schematische Darstellung des Schaltbildes der Vorrichtung gemäß Fig. 3; und
Fig. 5 eine schematische Darstellung eines erfindungsgemäßen Systems zur Detektion und lagegenauen Platzierung einzelner geladener Teilchen.

### Detaillierte Beschreibung der Erfindung

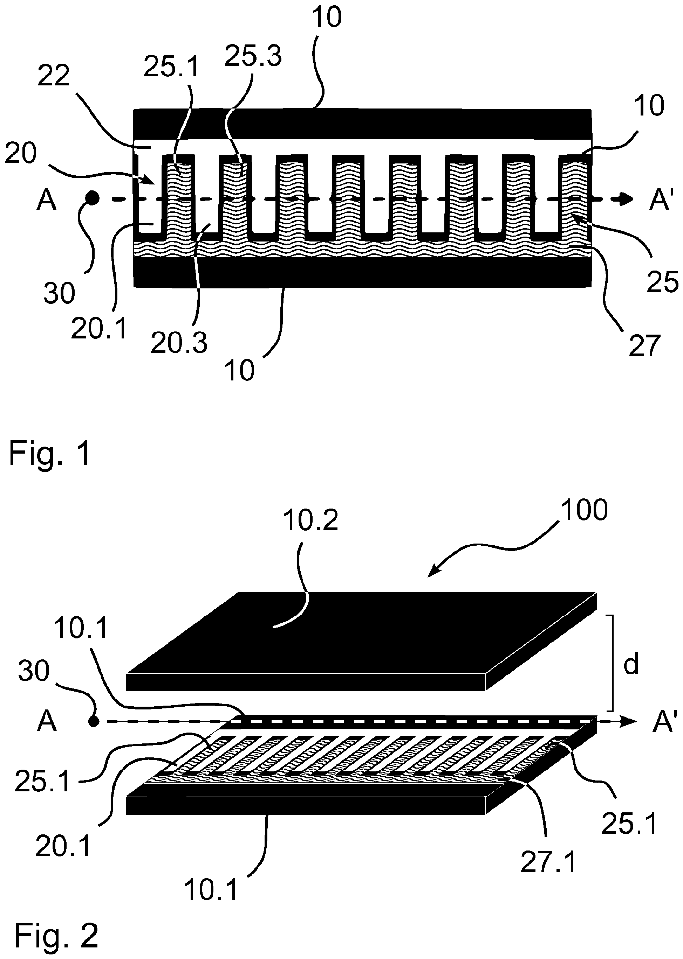

Figur 1 zeigt eine schematische Aufsichtsdarstellung einer Elektrodenanordnung, wie sie Verwendung in der erfindungsgemäßen Vorrichtung zur Detektion einzelner geladener Teilchen 30 finden kann. Die Elektrodenanordnungen sind jeweils als ineinandergreifende Elektrodenkämme 20, 25 mit einer Vielzahl von Zähnen, welche die einzelnen Elektroden 20.1, 20.3 bzw. 25.1, 25.3 bilden, ausgeformt. Die einzelnen Zähne der Kämme 20, 25 sind dabei über Verbindungsleitungen 22, 27 miteinander verbunden. Die gesamte Elektrodenanordnung mit den beiden Kämmen 20, 25 ist so auf einem elektrisch nicht leitfähigen Substrat 10 aufgebracht, dass die beiden ineinandergreifenden Kammstrukturen und insbesondere die ineinandergreifenden Zähne dieser Strukturen elektrisch gegeneinander isoliert sind. Weiterhin ist in dieser Aufsichtsdarstellung die senkrechte Projektion für ein zu detektierendes Teilchens 30, welches sich in einem gewissen Abstand oberhalb der gezeigten Elektrodenanordnung und mittig zwischen den beiden Kammstrukturen befindet, für eine bevorzugten Trajektorie entlang der Richtung A - A' gezeigt. Die beiden Elektrodenkämme 20, 25 sind lediglich zum Zwecke der besseren Unterscheidbarkeit in der Figur mit Schraffur (Elektroden 25.1, 25.3 mit Verbindungsleitung 27) und ohne Schraffur (Elektroden 20.1, 20.3 mit Verbindungsleitung 22) dargestellt.

Figur 2 zeigt eine schematische Darstellung erfindungsgemäßer Bestandteile einer Vorrichtung 100 zur Detektion einzelner geladener Teilchen 30. Die dargestellte Vorrichtung 100 umfasst zwei der in Figur 1 beschriebenen Elektrodenanordnungen. Die Elektrodenanordnungen befinden sich auf voneinander getrennten Substraten, wobei gemäß der gezeigten Darstellung ein unteres Substrat 10.1 und ein oberes Substrat 10.2 vorhanden sind. Die auf den jeweiligen Substraten vorhanden Elektrodenanordnungen sind einander zugewandt, so dass die einzelnen Elektroden 20.1, 25.1 des ersten und zweiten Elektrodenkamms 20, 25 auf dem unterem Substrat 10.1 und die in der Illustration nicht sichtbaren Elektroden des ersten und zweiten Elektrodenkamms auf dem oberen Substrat 10.2 exakt übereinanderliegend ausgerichtet sind. Aufgrund ihrer gegenseitigen Lage bilden sie zueinander jeweils einen nach zwei Seiten hin offenen Faraday-Käfig (bzw. einen Elementarkondensator) aus. Weiterhin ist in dieser Darstellung eine bevorzugte Trajektorie für den Durchflug eines zu detektierenden Teilchen 30 durch die erfindungsgemäße Vorrichtung entlang der Richtung A - A' gezeigt. Insbesondere ist dabei ein Durchflug in der Mitte zwischen den beiden Elektrodenanordnungen, in etwa auf halber Höhe des Abstands d und mittig zwischen den vier Kammstrukturen, bevorzugt. Die Darstellung dient nur der vereinfachten Illustration des Erfindungsprinzips. So kann die Anzahl der Elektroden, der Abstand d und eine Breite der Elektroden jeweils in Abhängigkeit von der geplanten Applikation festgelegt werden. Beispielsweise weist der Detektor 10⁴ Elektrodenpaare auf.

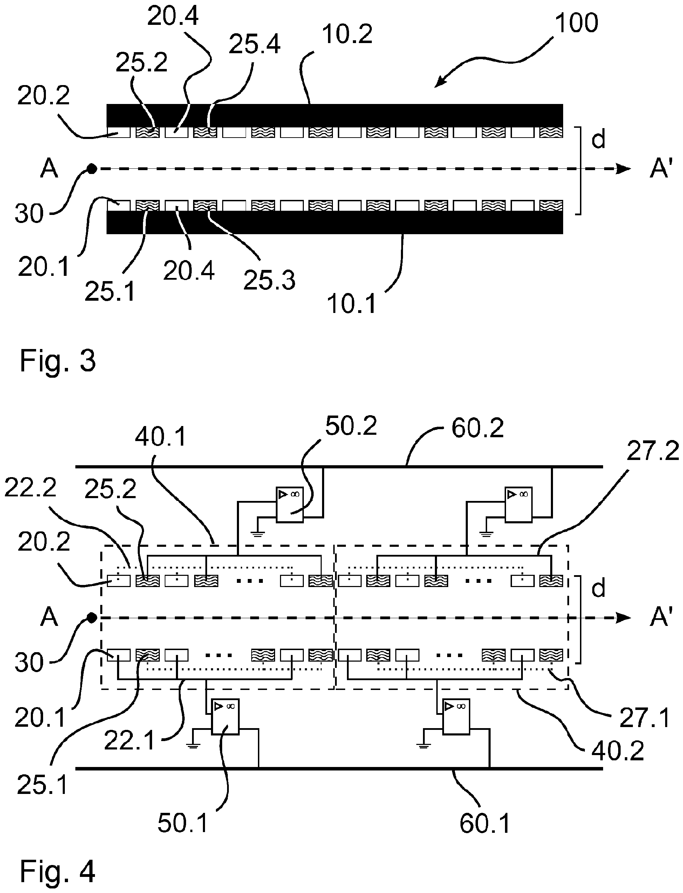

Figur 3 zeigt eine schematische Schnittdarstellung der Vorrichtung 100 gemäß der Ausführungsform nach Figur 2. Der Schnitt erfolgte hierbei entlang der in Figur 2 beispielhaft eingezeichneten und bevorzugten Teilchentrajektorie senkrecht zu den beiden übereinanderliegenden Elektrodenanordnungen. Die Zuordnung der einzelnen Bezugszeichen sowie die funktionalen Zusammenhänge der einzelnen Komponenten entsprechen der Beschreibung der Figuren 1 und 2. Zusätzlich wird hier jedoch die in Figur 2 perspektivisch nicht sichtbare zweite Elektrodenanordnung mit den einzelnen Elektroden 20.2, 20.4, 25.2, 25.4 des ersten und zweiten Elektrodenkamms auf dem oberen Substrat 10.2 und deren Ausrichtung bezüglich des unteren Substrats 10.1 erkennbar. So bilden die Elektroden 20.1 und 20.2 ein Elektrodenpaar im Sinne der Erfindung und sind elektrisch miteinander verbunden (hier nicht dargestellt). Ebenso bilden die nachfolgenden Elektroden 25.1 und 25.2 ein solches Elektrodenpaar.

Figur 4 zeigt eine schematische Darstellung des Schaltbildes der erfindungsgemäßen Vorrichtung 100 gemäß der Ausführungsform nach den Figuren 2 und 3. Das dargestellte Schaltbild entspricht dem Schnitt der in Figur 3 gezeigten Elektrodenanordnung und gibt deren interne Verschaltung wieder. Die Zuordnung der einzelnen Bezugszeichen sowie die funktionalen Zusammenhänge der einzelnen Komponenten entsprechen daher weitestgehend der Beschreibung der Figuren 1 und 2. Je zwei sich gegenüberliegende Elektroden 20.1 und 20.2 bzw. 25.1 und 25.2 sind elektrisch miteinander verbunden (hier nicht dargestellt) und bilden ein Elektrodenpaar.

Darüber hinaus sind in den durch die gestrichelte Linie umrissenen Abschnitten 40.1 und 40.2 einzelne Elektrodengruppen dargestellt, in denen die einzelnen Elektrodenpaare miteinander zu je zwei Signalgruppen verknüpft sind. So sind in der Elektrodengruppe 40.1 alle nicht schraffiert dargestellten Elektroden 20.1, 20.2 in einer ersten Signalgruppe zusammengefasst, während alle schraffierten Elektroden 25.1, 25.2 der Elektrodengruppe 40.1 eine zweite Signalgruppe bilden. Der ersten Signalgruppe ist eine Verstärkungsvorrichtung 50.1 auf dem unteren Substrat zugeordnet, während die zweite Signalgruppe auf eine Verstärkereinheit 50.2 auf dem oberen Substrat läuft. Dabei sind sowohl die einzelnen Elektrodengruppen untereinander als auch die darin enthaltenen Signalgruppen vollständig elektrisch voneinander getrennt.

Das von den Verstärkungsvorrichtungen 50.1, 50.2 verstärkte Signal der einzelnen Elektroden 20.1, 20.2 bzw. 25.1, 25.2 der einzelnen Elektrodengruppen wird anschließend über je eine Sammelleitung 60.1 bzw. 60.2 zeitrichtig entsprechend der geometrischen Abfolge der Elektroden gesammelt und abgeführt. Die generierten Signalfolgen in beiden Sammelleitungen 60.1, 60.2 werden nachfolgend durch eine geeignete Vorrichtung (nicht gezeigt) zu einem einzelnen Detektionssignal geformt, das über eine weitere Signalleitung (nicht gezeigt) einer nachgeschalteten Elektronik zur weiteren Auswertung zugeführt wird.

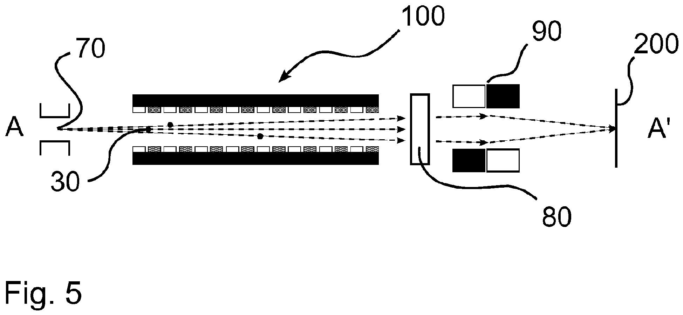

Figur 5 zeigt eine schematische Darstellung eines erfindungsgemäßen Systems zur Detektion und lagegenauen Platzierung einzelner geladener Teilchen. Das System umfasst die vorab beschriebene Vorrichtung 100. Der Vorrichtung 100 vorgeschaltet findet sich eine Strahlungsquelle 70. Nachgeordnet folgen ein Strahlabschalter 80 und eine Fokussiereinheit 90. Mit der Strahlungsquelle 70 wird ein Strahl aus geladenen Teilchen 30 mit geringer Stromdichte und ausreichend hoher Emittanz für eine nachgelagerte Fokussierung erzeugt. Die Fokussiereinheit 90 umfasst beispielsweise zwei hintereinander angeordnete und um 90° zueinander verdrehte permanente oder elektrisch betriebene Quadrupolmagnete. Eine schnell regelbare Strahlabschaltung dient als Strahlunterbrecher 80 zur Regulierung und Steuerung des Strahldurchlasses. Durch die Strahlabschaltung 80 in Kombination mit der Vorrichtung 100 zur Detektion einzelner geladener Teilchen 30 wird sichergestellt, dass nur solche Teilchen durchgelassen und auf oder in eine Probe 200 gelenkt werden, deren Detektionssignal alle bei einem Teilchendurchtritt durch den Detektor zu erwartenden Merkmale aufweist. Auf diese Weise kann beispielsweise eine gezielte Materialbearbeitung durch lagegenaue Platzierung der Teilchen auf oder in der Probe 200 erfolgen.

## Patentansprüche

1. Vorrichtung (100) zur Detektion eines einzelnen geladenen Teilchens (30) im einfachen freien Durchflug, umfassend:
- mindestens zwei Elektrodenanordnungen mit einer Vielzahl von regelmäßig angeordneten Elektroden (20, 25), wobei die Elektroden (20, 25) der Elektrodenanordnungen quer zur Flugrichtung des Teilchens (30) so übereinander positioniert sind, dass sich ein konstanter Abstand (d) zwischen den jeweiligen Elektroden (20, 25) ergibt und die Elektroden (20, 25) exakt übereinanderliegend ausgerichtet sind dergestalt, dass das zu detektierende Teilchen (30) den so gebildeten Zwischenraum im freien Flug durchquert; und
- eine Schaltung, bei der Paare aus sich gegenüberliegenden Elektroden (20, 25) über Verbindungsleitungen (22, 27) elektrisch miteinander verbunden und über ladungsempfindliche Verstärkungsvorrichtungen (50.1, 50.2) auf Sammelleitungen (60.1, 60.2) geschaltet sind.

2. Vorrichtung nach Anspruch 1, bei der sich die Elektrodenanordnungen auf isolierenden Trägersubstraten (10.1, 10.2) befinden.

3. Vorrichtung nach einem der vorhergehenden Ansprüche, bei der die Elektrodenanordnungen jeweils als ineinandergreifende Elektrodenkämme mit einer Vielzahl von Zähnen, welche die einzelnen Elektroden (20, 25) bilden, ausgeformt sind.

4. Vorrichtung nach einem der vorhergehenden Ansprüche, bei der die beiden Elektrodenanordnungen 10² bis 10⁶ Elektrodenpaare umfassen.

5. Vorrichtung nach einem der vorhergehenden Ansprüche, bei der zwei oder mehr aufeinanderfolgende Paare aus sich gegenüberliegenden Elektroden (20, 25) zu einer Elektrodengruppe zusammengefasst sind, der Verstärkungsvorrichtungen (50.1, 50.2) zugeordnet sind.

6. Vorrichtung nach Anspruch 5, bei der eine Elektrodengruppe jeweils 50 bis 5*10² Elektrodenpaare umfasst.

7. Vorrichtung nach Anspruch 5 oder 6, bei der die Sammelleitungen (60.1, 60.2) so gestaltet sind, dass die Signale der einzelnen Elektrodengruppen zeitrichtig entsprechend der geometrischen Abfolge der Elektroden (20, 25) gesammelt und abgeführt werden.

8. Vorrichtung nach einem der vorhergehenden Ansprüche, bei der der Abstand (d) zwischen gegenüberliegenden Elektroden (20, 25) eines Elektrodenpaares 100 nm bis 10 mm beträgt.

9. Vorrichtung nach einem der vorhergehenden Ansprüche, bei der eine Breite der Elektroden (20, 25) 100 nm bis 10 mm beträgt.

10. System zur Materialbearbeitung mit einzelnen geladenen Teilchen umfassend:
- eine Vorrichtung (100) zur Detektion einzelner geladener Teilchen (30) nach einem der vorhergehenden Ansprüche;
- einen Strahlunterbrecher (80); und
- eine Fokussiereinrichtung (90).

## Claims

1. A device (100) for detecting an individual charged particle (30) during a single free fly-through comprising:
- at least two electrode arrangements with a plurality of regularly arranged electrodes (20, 25), wherein the electrodes (20, 25) of the electrode arrangements are positioned above one other transversely to the flying direction of the particle (30) in such a manner that a constant distance (d) between the respective electrodes (20, 25) results and the electrodes (20, 25) are exactly aligned one above the other in such a manner that the particle (30) being detected crosses the intermediate space formed in this way in free flight and
- a circuit in which pairs of opposite electrodes (20, 25) are electrically connected to one another via connection lines (22, 27) and are switched via charge-sensitive amplification devices (50.1, 50.2) to busbars (60.1, 60.2).

2. The device according to claim 1, wherein the electrode arrangements are located on insulating carrier substrates (10.1, 10.2).

3. The device according to one of the preceding claims, wherein the electrode arrangements are each designed as intermeshing electrode combs having a plurality of teeth which form the individual electrodes (20, 25).

4. The device according to one of the preceding claims, wherein the two electrode arrangements comprise 10² to 10⁶ pairs of electrodes.

5. The device according to one of the preceding claims, wherein the two or more consecutive pairs of opposite electrodes (20, 25) are combined into an electrode group which is assigned amplification devices (50.1, 50.2) .

6. The device according to claim 5, wherein an electrode group comprises 50 to 5*10² pairs of electrodes in each case.

7. The device according to claim 5 or 6, wherein the busbars (60.1, 60.2) are formed in such a manner that the signals of the individual electrode groups are collected and fed away at the right time according to the geometric sequence of the electrodes (20, 25).

8. The device according to one of the preceding claims, wherein the distance (d) between opposite electrodes (20, 25) of a pair of electrodes amounts to 100 nm to 10 mm.

9. The device according to one of the preceding claims, wherein a width of the electrodes (20, 25) amounts to 100 nm to 10 mm.

10. A system for material processing with individual charged particles comprising:
- a device (100) for detecting individual charged particles (30) according to one of the preceding claims;
- a beam interrupter (80) and
- a focusing device (90).

## Revendications

1. Dispositif (100) de détection d'une particule chargée individuelle (30) dans le survol libre simple, comprenant :
- au moins deux agencements d'électrodes avec une pluralité d'électrodes (20,25) disposées régulièrement, dans lequel les électrodes (20,25) des agencements d'électrodes sont disposées transversalement à la direction de vol de la particule (30) l'une au-dessus de l'autre de telle sorte qu'un écart constant (d) entre les électrodes respectives (20,25) soit obtenu et les électrodes (20,25) sont orientées en étant exactement superposées de telle sorte que la particule à détecter (30) traverse l'espace intermédiaire ainsi formé en vol libre ; et
- un circuit, dans lequel des paires d'électrodes en vis-à-vis (20,25) sont reliées électriquement les unes aux autres par l'intermédiaire de lignes de liaison (22 ,27) et sont branchées par l'intermédiaire de dispositifs d'amplification sensibles à la charge (50.1, 50.2) sur des lignes collectrices (60.1,60.2).

2. Dispositif selon la revendication 1, dans lequel les agencements d'électrodes se trouvent sur des substrats porteurs isolants (10.1,10.2).

3. Dispositif selon une des revendications précédentes, dans lequel les agencements d'électrodes sont façonnés respectivement comme des peignes d'électrodes s'engrenant les uns dans les autres avec une pluralité de dents, qui forment les électrodes individuelles (20,25).

4. Dispositif selon une des revendications précédentes, dans lequel les deux agencements d'électrodes de comprennent 10² à 10⁸ paires d'électrodes.

5. Dispositif selon une des revendications précédentes, dans lequel deux ou plus paires successives composées d'électrodes en vis-à-vis (20,25) sont assemblées en un groupe d'électrodes, auxquels des dispositifs d'amplification (5.1,50.2) sont coordonnés.

6. Dispositif selon la revendication 5, dans lequel un groupe d'électrodes comprend respectivement 50 à 5*10² paires d'électrodes.

7. Dispositif selon la revendication 5 ou 6, dans lequel les lignes collectrices (60.1,60.2) sont conçues de telle sorte que les signaux des groupes d'électrodes individuelles soient collectés et sortis à l'instant correct correspondant à la succession géométrique des électrodes (20,25).

8. Dispositif selon une des revendications précédentes, dans lequel l'écart (d) entre des électrodes en vis-à-vis (20,25) d'une paire d'électrodes est compris entre 100 nm et 10 mm.

9. Dispositif selon une des revendications précédentes, dans lequel une largeur des électrodes (20,25) est comprise entre 100 nm et 10 mm.

10. Système d'usinage de matériau avec des particules chargées individuelles comprenant :
- un dispositif (100) de détection de particules chargées individuelles (30) selon une des revendications précédentes ;
- un brise-jet (80) ; et
- un dispositif de focalisation (90).
